# EUROPEAN PATENT APPLICATION

(11) **EP 1 583 161 A1**
(43) Date of publication of application: **05.10.2005**
(21) Application number: 04700755.4
(22) Date of filing: 08.01.2004
(51) Int. Cl.: H01L 35/26, H01L 21/324, H01M 14/00

(54) **STRUCTURALLY GRADIENT MATERIAL AND FUNCTIONAL ELEMENT INCLUDING THE SAME**

(30) Priority: 09.01.2003 JP 2003003192
(71) Applicant: Japan as represented by President of Kanazawa University, Ishikawa 920-1192 (JP); IHI Aerospace Co., Ltd., Tokyo 100-8182 (JP)
(72) Inventor: HATA, Tomonobu, Kanazawa-shi, Ishikawa 9218103 (JP); SASAKI, Kimihiro, Kanazawa-shi, Ishikawa 9218112 (JP); MORITA, Shinichi, c/o IHI AEROSPACE Co. Ltd., Chiyoda-ku, Tokyo 1008182 (JP)
(74) Representative: Grünecker, Kinkeldey, Stockmair & Schwanhäusser Anwaltssozietät
(86) International application number: PCT/JP2004/000055
(87) International publication number: WO 2004/064169

(57) **Abstract**

There is disclosed a gradient structure material comprising a substrate 1 and a functional material 2 formed on the substrate. The gradient structure material is thermally treated while a desired gradient temperature is applied to a specific direction and a specific region of the functional material on the substrate. Consequently, without adding "gradient structure" of a component concentration, a content of oxide, or a crystal structure, the functional material on the substrate is provided with useful function which is not heretofore existed, or a performance can be enhanced unlike a conventional technique.

## Description

### BACKGROUND OF THE INVENTION

### Field of the Invention

The present invention relates to a gradient structure material having a functional material on a substrate, and a functional element using this material.

### Description of the Related Art

A material (referred to as the "gradient composition material") has heretofore been known which composition gradually changes in the same material (see, e.g., Patent Documents 1 to 5).
[Patent Document 1]
   Jpn. Unexamined Publication No.
[Patent Document 2]
   Jpn. Unexamined Publication No. 2000-211927
[Patent Document 3]
   Jpn. Unexamined Publication No. 06-145839
[Patent Document 4]
   Jpn. Unexamined Publication No. 2000-17357
[Patent Document 5]
   Jpn. Unexamined Publication No. 11-340141

In a "method of manufacturing a composite of organic polymer and metal oxide having a component concentration gradient structure" of [Patent Document 1], solid organic polymer is impregnated with metal alkoxide in such a manner as to have gradient concentration, and thereafter metal alkoxide is condensation-polymerized and immobilized as metal oxide.

Moreover, as to "a method of manufacturing a composite material using sedimentation of sol and gel, and a material obtained in the method" of [Patent Document 2], sol comprising metal alkoxide of two or more components, or gel-containing sol is formed into a composite precursor of gel which has a molecule gradient structure in which a component concentration continuously changes in a molecule scale. In the forming, a difference of a sedimentation speed is made between structure particles by a centrifugal treatment, and this difference is utilized. The precursor is thermally treated to prepare the composite material.

Therefore, [Patent Document 1] and [Patent Document 2] relate to the "gradient composition material " which component concentration changes in the same material.

Moreover, in "an oxide dispersed type alloy, a method of manufacturing the alloy, and a preparation apparatus" of [Patent Document 3], a material to be sintered contains a metal and oxide having a melting point which is lower than a sintering temperature of the metal, and the material is sintered under a gradient temperature in such a manner that a part of the material is at a temperature which is not less than the melting point of oxide. Accordingly, oxide is dispersed in such a manner as to constitute a gradient structure in which a content of oxide continuously increases from a part of the material to be sintered to the other part.

Furthermore, in "a gradient function alloy and a method of manufacturing the alloy" of [Patent Document 4], the alloy comprises a composition containing 3 to 10% by weight of Al, 5 to 20% by weight of Mn, and a balance of Cu and unavoidable impurities. The alloy has a third portion which crystal structure changes continuously or in a stepwise manner between a first portion substantially comprising a β single layer, and a second portion substantially comprising a α phase and a Heusler phase.

[Patent Document 3] and [Patent Document 4] relate to a "gradient composition material " indicating that the content of oxide or the crystal structure change in the same material, and have a characteristic that a gradient temperature is applied at a manufacturing time.

Moreover, in "a method of manufacturing a semiconductor substrate" of [Patent Document 5], an insulator layer on the surface of a substrate is partially removed to form an exposed face of the substrate surface. Thereafter, an epitaxial growing process is performed on conditions that the gradient temperature is reduced in a thickness direction of the substrate, and increased in a diametric direction of the substrate. Accordingly, a single-crystal silicon layer is formed on the insulator layer.

As described above, a process of manufacturing a material having a certain function (referred to as "functional material") has heretofore necessarily included a certain thermal treating process. A thermal treatment will be hereinafter referred to simply as the "thermal treating process".

The thermal treating process is generally performed at a uniform temperature over a material, a homogeneous material property is achieved, and a performance is enhanced in some case (see Patent Documents 1 and 2). Even when the gradient temperature is applied in manufacturing it, the temperature of each portion is constant (see Patent Documents 3, 4, 5).

Moreover, as to a thin film on the substrate, the following means are used for enhancing the performance of the functional element utilizing the functional material on the substrate: (1) complete crystallizing means for epitaxially growing the film on the single-crystal substrate; (2) means for controlling impurities with high precision; (3) means for aiming the enhancement of the material performance only by homogenization of the film; and (4) means forming a super lattice structure in which a plurality of thin films having different composition ratios in multiple layers, a gradient structure of the composition or the like.

These means need to control important parameters relating to the film formation, such as a film forming speed, temperature, composition, vacuum degree, impurities and raw materials in a sophisticated manner, and the apparatus necessarily becomes very expensive.

Moreover, as to the material having a thickness close to that of a bulk, the following means are used for the performance enhancement: (5) means for controlling raw material purity and composition ratio with high precision; (6) means for orienting material axis; (7) means for forming composite structure. In these cases, a highly precisely controllable apparatus is required, a process becomes expensive, and costs utilizing the functional material increase.

Above all processes include a thermal treating process because the uniformity of the physical properties is important. That is, the material is thermally treated in a plane or in a thickness direction, while each portion having a uniform temperature or a gradient temperature is retained at a constant temperature.

As described above, the functional material on the substrate for use in each functional element has heretofore been uniformly thermally treated on the same condition. Therefore, it is supposed that the physical properties are substantially same in the plane or in the thickness direction. When there is a gradient temperature, but when each portion is retained at a constant temperature, it is supposed that the physical properties are approximately same in the plane or the thickness direction, unless the component concentration, the content of oxide, and the crystal structure change in the gradient composition material.

Furthermore, as to the thin film, a highly-precisely controllable film formation apparatus is required, and film forming costs remarkably increase. Also in the material having a thickness close to that of the bulk, a highly-precisely controllable material formation apparatus is required as in the thin film. In either case, the manufacturing apparatus needs to be complicated and high performance is required. In consideration of the cost of the functional element with respect to the performance, an advantage cannot be obtained, when the expensive apparatus is introduced to prepare the element. Therefore, there is a problem that it is difficult to sufficiently enhance the performance of the functional element.

### SUMMARY OF THE INVENTION

The present invention has been developed in view of the above-described conventional situations. That is, an object of the present invention is to provide a gradient structure material and a functional element using this material, in which, unlike a conventional technique, a useful function is applied to a functional material on a substrate, or a performance can be enhanced without adding "gradient composition" of a component concentration, a content of oxide, a crystal structure or the like,

In the present invention, there is proposed a material (hereinafter referred to as the "gradient structure material") in which there is not any "gradient composition" of the component concentration, the content of oxide, the crystal structure or the like, but a material structure changes gradually in the same composition.

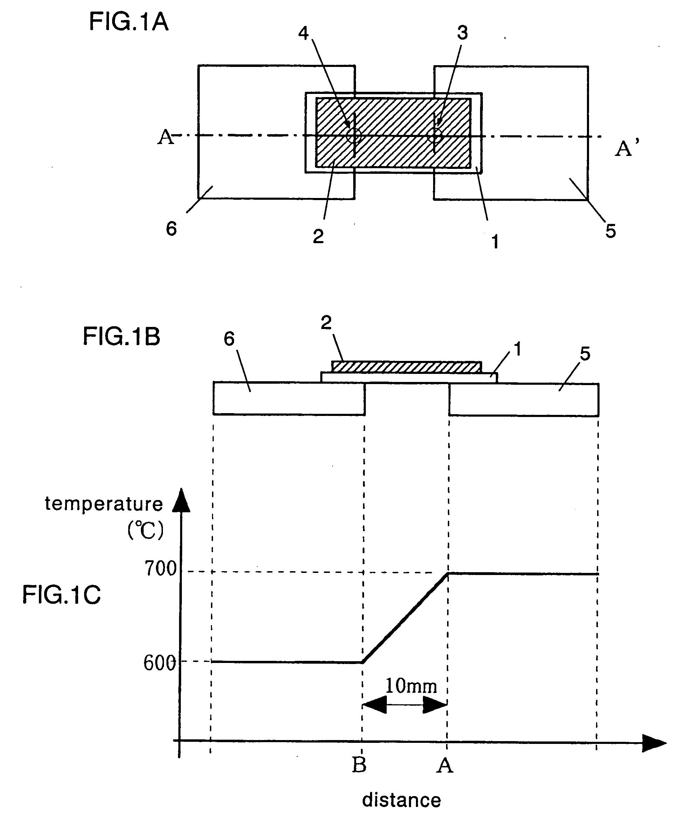

The "gradient structure material " of the present invention will be described with reference to examples of FIGS. 1A, 1B and 1C. Here, a thin film on a substrate will be described, but the present invention is not limited to the thin film, and is applicable to a material having a thickness close to that of a bulk.

A thin film 2 is formed on a substrate 1 by various types of thin film forming techniques, and the film is thermally treated while a gradient temperature is applied in one direction between two points: an A-point region 3; and a B-point region 4 in one direction in the plane of the thin film 2. Here, the "thermal treatment" means both of a usual thermal treatment and a heating.

The gradient temperature can changes with a thermal treatment temperature, material type, composition, film forming condition, dimension, and substrate. For example, as shown in FIG. 1C, when a maximum thermal treatment temperature is set at 700 degree C, the A-point region 3 is set on a high-temperature side at maximum 700 degree C, and the B-point region 4 is set on a low-temperature side at maximum 600 degree C, while the thermal treatment is performed. It is to be noted that in the present invention, the treatment is performed while the gradient temperature is applied to the A-point region 3 and the B-point region 4. Therefore, the A-point region 3 is heated from a low temperature to maximum 700 degree C while retaining the gradient temperature. Moreover, the B-point region 4 is heated from the low temperature to maximum 600 degree C while retaining the gradient temperature.

Therefore, a distance is maintained to be constant (e.g., 10 mm) between the A-point region 3 and the B-point region 4. With the increase of the thermal treatment temperature, a uniform gradient temperature 7 of a maximum value of 100 degree C per a centimeter is applied between the A-point region 3 and the B-point region 4, and the thin film is thermally treated. By this thermal treatment, the A-point region 3 takes an inherent material structure thermally treated at a maximum temperature of 700 degree C, and the B-point region 4 obtains an inherent material structure thermally treated at 600 degree C.

The "material structure" mentioned herein indicates not only a crystallographic structure but also general structures such as an energetics structure and a physical structure. Since a region between the A-point region 3 and the B-point region 4 is thermally treated with the constant gradient temperature 7, the region has the material structure inherent in each thermal treatment temperature in accordance with a distance from each point. The thermal treatment temperature uniformly differs from the A-point region 3 to the B-point region 4 in the material structure, but it seems as if the temperature uniformly changed. When the thermal treatment is performed while the gradient temperature 7 is applied between two points, the material structure uniformly changes between two points. This material is referred to as the "gradient structure material". When the gradient structure is applied to the material in this manner, physical properties of the material are greater than those of a conventional material heated at a constant temperature or thermally treated. This effect is referred to as the "gradient structure effect".

By this gradient structure effect, the following phenomena have been confirmed this time: (1) a specific resistance of the material decreases by digits; (2) a rectifying function exists between points A and B; (3) an electromotive voltage is generated between the points A and B; (4) a material can be produced in such a manner as to have uniform color gradient between the points A and B. Consequently, it is possible to enhance by digits the performances of physical properties relating to an electrically conductive carrier of the material. Since a thermal treatment furnace for applying the gradient temperature does not require any especially high-performance apparatus, a manufacturing technique becomes inexpensive.

Moreover, the gradient structure material according to the present invention relates to means for performing a thermal treatment while applying a gradient temperature to a functional material on a substrate as described in claim 1, and claim 2 relates to functionality associated with properties of an electrically conductive carrier. Claims 3 and 4 relates to the material on the substrate at or after formation, claim 5 relates to a thermal treatment atmosphere, claims 6 to 10 relate to characteristic of the gradient temperature, claims 11 to 15 relate to characteristics of the material, and claim 16 relates to a semiconductor compatible to a Si process.

Furthermore, claims 17 and 18 relate to examples of the gradient structure material according to a specific embodiment.

Furthermore, claims 19 to 22 are characterized in a functional element to which the gradient structure material is applied, and claim 23 is characterized in a combination of various means which are performance enhancing measures, and the gradient structure material.

In the gradient structure material according to the present invention, a thin film before the thermal treatment, or a material having a thickness close to that of a bulk may be formed by conventional means. When simple means for performing the thermal treatment is used while an optimum gradient temperature is disposed in a thermal treatment process at the time of material process, material physical properties can be remarkably enhanced without using any especially expensive apparatus.

This means does not limit types such as a metal, semiconductor, and insulator (including inorganic and organic materials), configuration, composition, forming method, dimension and the like of the material, and the means is applicable to any material. Therefore, the application in a broad field of the material is possible. With respect to a functional material and an element using the functional material, functionalities can be enhanced than before, such as an electric property, optical property, thermal property, magnetic property, thermoelectric property, photoelectric property, electromagnetic property, ferroelectric property, piezoelectric property, pyroelectric property, and superconductivity.

Especially, a property that an electric resistivity (specific resistance) decreases by digits by the gradient structure effect has been unattainable by a conventional uniform thermal treatment. As to this property, since noises can be reduced in the electric property of the functional element, an S/N performance of the functional element can be enhanced. As a result, signal detection and processing are facilitated. Since the specific resistance is small, the use as a wire in the functional element is also possible, and it is possible to reduce a power loss of the functional element. Furthermore, since the specific resistance is small, the use in a high-speed functional element is also possible.

The use of the rectifying function at a specific temperature easily makes possible protection of a circuit, and conversion of an alternating current into a direct current. Additionally, since there is not any bonding interface like pn-bonding, a withstand voltage of a rectifying functional element can also be increased. Another functional element is possible that is configured to pass a current only through a specific temperature region. Concerning a property of generation of an electromotive voltage, a functional element is possible like a battery when directly used. As to the property of color gradient, it is possible to apply an inherent structure color which is supposed to depend on an energy state of the material depending on the application of the gradient temperature to the material.

The thermal treatment for applying the gradient temperature is comparatively simple, and the material manufacturing method necessarily requires a certain thermal treatment. Therefore, since it is not especially necessary to add a new process for manufacturing, the processes are not complicated, and are compatible with a conventional manufacturing process. Therefore, it is possible to inexpensively prepare a highly functional material, a high-performance functional element, an electromotive voltage generating functional element, or a color gradient material.

When the gradient structure material according to the present invention is used, the S/N performance of the functional element can be largely enhanced. Furthermore, since the generation of the electromotive voltage is confirmed, a new energy generating functional element is possible. As to the color gradient, a structure color can be assigned to the material only by the thermal treatment with the gradient temperature. As to the structure color, since any coating material is not used, coloring is eco-friendly.

According to the gradient structure material formed by the thermal treatment with the gradient temperature in the present invention, the performance of the functional element using this material can be enhanced. By the use of the means, the S/N can be largely enhanced without using various expensive film forming means, toxic material, or material unfavorable for the environment.

Furthermore, the thermal treatment is required for the material process, but the gradient temperature is only applied at this time. Therefore, any special, expensive, new process is not required. In the thin film, after manufacturing the film by a conventional film forming apparatus, the S/N can be enhanced by the thermal treatment with the gradient temperature.

Moreover, when the thin film on the substrate has an amorphous state after formed, it is easier to prepare the gradient structure material. A single-crystal substrate does not have to be used as the substrate, and the film may be formed on inexpensive glass, ceramic, or Si semiconductor. The film may be formed on an organic material or the like, if permitted at a heat-resistant temperature. The functional element may be formed on the substrate.

Furthermore, since an amorphous film is preferable, a substrate temperature may be room temperature, gas is hardly generated by substrate heating, and an exhaust time may be short until a vacuum degree suitable for film formation is reached. Consequently, the film forming process is simplified, most of conventional material processes are usable, and costs of process technique can be reduced.

Additionally, when the gradient structure material is a semiconductor, a smaller specific resistance is possible as compared with the material prepared by the conventional means. Therefore, by the use of the material in the functional element, a functional element having small power consumption is possible, and it is possible to apply the material to a high-speed functional element. Since it is possible to apply a limited gradient temperature to a required portion for the thermal treatment with the gradient temperature, it is possible to impart the gradient structure effect only to a region required for the functional element.

Moreover, after a thin-film region on the substrate is once heated or thermally treated at a constant temperature, the region is subjected to the thermal treatment with the gradient temperature. Even in this case, the physical properties of the thin film on the substrate are hardly influenced. Therefore, a process of forming the gradient structure material is compatible with a conventional material forming process, and is also compatible with a conventional semiconductor process. The thermal treatment with the gradient temperature after the film formation has been described, but this also applies to a gradient structure material obtained by forming the film in a state in which the substrate is heated with the gradient temperature.

Other objects and advantageous characteristics of the present invention will be apparent from the following description with reference to the accompanying drawings.

### BRIEF DESCRIPTION OF THE DRAWINGS

FIG. 1A is a plan view showing a first embodiment of a gradient structure material according to the present invention, FIG. 1B is a sectional view, and FIG. 1C is a schematic diagram of a gradient temperature;
FIG. 2A is a plan view showing a third embodiment of the gradient structure material according to the present invention, FIG. 2B is a sectional view, and FIG. 2C is a schematic diagram of the gradient temperature;
FIG. 3 schematically shows an example of a thin film before thermal treatment according to an example of the present invention;
FIG. 4 is a relation diagram between the gradient temperature and an average thermal treatment temperature;
FIG. 5 is a relation diagram between a specific resistance and the average thermal treatment temperature according to the present invention;
FIG. 6 is a relation diagram between an electromotive voltage and the average thermal treatment temperature according to the present invention;
FIG. 7A is a diagram at the time of a thermal treatment temperature decrease, showing a relation between the specific resistance and the average thermal treatment temperature with respect to different applied voltages according to the present invention, and FIG. 7B is a diagram when the thermal treatment temperature increase;
FIG. 8A shows another example corresponding to FIG. 4, and FIG. 8B shows another example corresponding to FIG. 5; and
FIGS. 9A, 9B, 9C show another three examples corresponding to FIG. 5.

### DESCRIPTION OF THE PREFERRED EMBODIMENTS

Preferable embodiments of the present invention will be described hereinafter with reference to the drawings. It is to be noted that components common to each diagram are denoted with the same reference numerals, and redundant description is omitted.

FIGS. 1A, 1B, 1C are explanatory views of a first embodiment of the present invention. A thin film 2 is formed on a substrate 1 set at a desired temperature by thin film forming means.

The substrate 1 is suitable for applying a gradient temperature in a thermal treatment furnace, a material having a comparatively low thermal conductivity is preferable such as a semiconductor or an insulator, but the material of the substrate is not limited. It is not important whether or not the material of the substrate 1 is crystallized, and a single-crystal, polycrystal, ceramic, glass or the like may be used. A functional element or an electronic circuit may be formed on the substrate 1. Thin film forming means may be performed by: a vacuum evaporation process which is a gas phase growth process; physical film forming processes such as a sputtering process, an ion plating process, a molecular beam epitaxy process, and an atomic beam epitaxy process; various types of chemical film forming (CVD) process; liquid-phase growth processes such as a fused solution epitaxy process and a solution epitaxy process and the like.

To form the gradient structure material, since the thin film preferably has an amorphous state, in physical thin film forming means, a substrate temperature may be used at which the thin film is not crystallized (becomes amorphous). Other examples of means for forming the amorphous thin film to prepare the gradient structure material include: means for implanting impurities into the thin film on the crystallized substrate; means for forming the amorphous thin film by a laser annealing process or an electron beam process simultaneously with a thermal treatment and the like. However, the amorphous thin film forming means is not limited.

As to the crystallized thin film, the thermal treatment temperature may be raised. Alternatively, means may be used for forming the amorphous thin film and subjecting the film to the thermal treatment with the gradient temperature. The thin film 2 may be formed of a single-element or multi-element compound, and may have various types of multilayered structures. A material of the thin film may be a semiconductor, insulator, electric conductor, or super electric conductor. Furthermore, an inorganic or organic material may be used.

The gradient of the temperature (gradient temperature) has been described with respect to a specific direction in a plane of the thin film on the substrate, but the gradient of the temperature may be applied in a thickness direction or a combined direction of in-plane and thickness directions. It is supposed that a strain is generated in the thin film because the thermal treatment with the gradient temperature is performed. Therefore, a coefficient of thermal expansion of the thin film 2 is preferably substantially equal to that of the substrate 1. However, when there is not any problem of a generated strain, for example, when the thin film is formed on the ceramic substrate 1, an adhesion area is broad, and therefore it is supposed that an influence of the strain is reduced. Therefore, it is also supposed that an influence of the thermal expansion coefficient is not exerted, or is little. When the thermal treatment temperature is comparatively low, the influence of the strain on the film is supposed to be small.

A gradient temperature 7 (or temperature difference at 100 degree C) is applied between two points: an A-point region 3; and a B-point region 4 having a distance of 10 mm therebetween in a desired direction in a thin film 2 plane, and a thermal treatment is performed in the pressure of one atmosphere of nitrogen gas.

An optimum value of the gradient temperature sometimes differs with types, compositions, film forming conditions, dimensions, and substrates of the material. An example is illustrated here, and the value of the gradient temperature is not limited. The gradient temperature may change with up/down of the thermal treatment temperature. As to the atmosphere gas under a thermal treatment, one atmosphere nitrogen gas is used, but the pressure and inactive gas type are not limited. A slight amount of gas of hydrogen, oxygen or the like may be mixed in an inactive gas because of a terminating process of the gradient structure thin film.

The distance between the A-point region 3 and the B-point region 4 may be optimized by the gradient temperature 7 to be applied, thermal treatment temperature, and dimension of a region where the gradient structure material is to be formed. For example, when the highest thermal treatment temperature is 700 degree C, the gradient temperature is applied at 700 degree C which is a temperature of a high-temperature side heat sink 5 brought into thermal contact with the A-point region 3, in such a manner as to reach 600 degree C which is a temperature of a low-temperature side heat sink 6 brought into thermal contact with the B-point region 4. In this case, the gradient temperature is supposed to have a uniformly changed state, but the gradient temperature on the high-temperature side may differ from that in the vicinity of the low-temperature side.

The high-temperature side heat sink 5 and the low-temperature side heat sink 6 are preferably thermal conductors, and a material suitable at the thermal treatment temperature may be used. A way to heat the heat sink is diversified, but heating means is not limited, and the heating means may be direct heating means by a heating wire, or indirect heating means by a heating wire, laser, electron beam, microwave or the like.

By this thermal treatment, the thin film is thermally treated with the uniform gradient temperature 7 (100 degree C per millimeter) from the A-point region to the B-point region. In this case, an average thermal treatment temperature is 650 degree C. The A-point region 3 obtains an inherent material structure thermally treated at 700 degree C, and the B-point region 4 obtains an inherent material structure thermally treated at 600 degree C.

The material structure mentioned herein indicates not only a crystallographic structure but also general structures such as an energetics structure and a physical structure. When a region between the A-point region 3 and the B-point region 4 is thermally treated with the constant gradient temperature 7, the region has the material structure inherent in the thermal treatment temperature in accordance with a distance from each point. The thermal treatment temperature uniformly differs from the A-point region 3 to the B-point region 4 in the material structure, but it seems as if the temperature uniformly changed. When the thermal treatment is performed while the gradient temperature 7 is applied to one direction between two points, the material structure uniformly changes between two points. A gradient structure effect has been founded to be indicated in such a manner that physical properties of the material are greater than those of a conventional material, when the gradient structure is applied to the material.

A second embodiment of the present invention relates to a gradient structure material obtained by a thin film on a substrate in a state in which the substrate is provided with a gradient temperature to set a substrate temperature in forming a film of a functional material by various thin film forming means. The embodiment also relates to a functional element using the gradient structure material. In this case, a vacuum degree with which the thin film on the substrate is formed is not limited, and a micro amount of a hydrogen or oxygen gas may be introduced into a vacuum apparatus in terminating the thin film. There is no limitation as to a type, configuration or the like of the material of the substrate. A circuit may be formed on the substrate. There is not any limitation with respect to thin film forming means, whether or not the structure is multilayered, or whether or not the structure is composite.

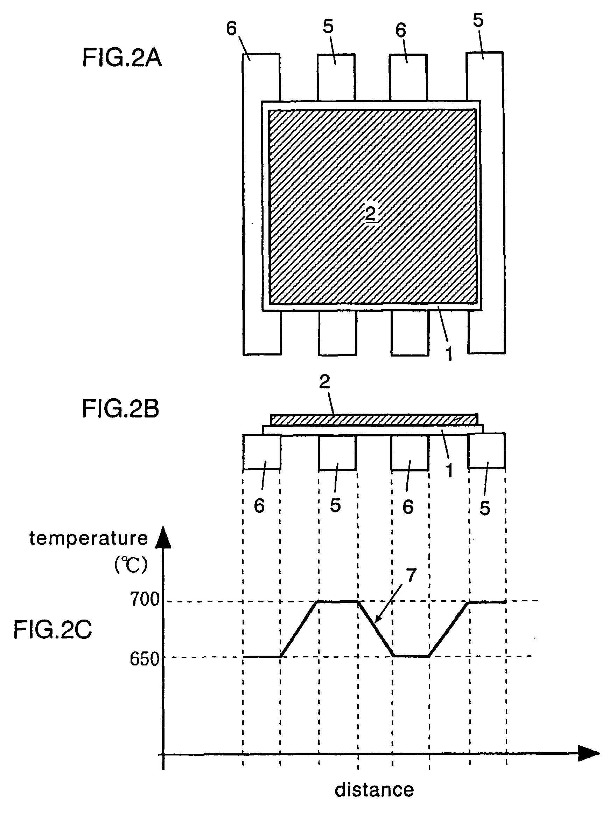

FIGS. 2A, B, C are explanatory views of a third embodiment of the present invention. It has been described that a constant gradient temperature is applied to one direction and region between two points in a specific direction. As shown in FIGS. 2A, B, C, when high-temperature side heat sinks 5 and low-temperature side heat sinks 6 are disposed in a plurality of positions, gradient temperatures may be applied to a plurality of positions, and a plurality of required regions may be provided with gradient structure.

Here, one example is illustrated, but there is also considered means for applying geometrically various gradient temperatures, and there is not any limitation to a geometric arrangement of the high-temperature side heat sinks 5 and the low-temperature side heat sinks 6 to which the gradient temperatures are applied. There is not any limitation to a way of heating. It has been described that a constant gradient is applied between the high-temperature side heat sink 5 and the low-temperature side heat sink 6, but the gradient is not necessarily constant, the gradient may have a designed pattern, and the gradient temperature may differ in the vicinities of the high-temperature and low-temperature side sinks.

The gradient temperature has been described in the in-plane direction of the thin film, and the gradient temperature may be applied in a thickness direction or a composite direction. The gradient temperatures may be applied to a plurality of positions on the substrate at the time of the formation of the thin film to set a substrate temperature.

In the first to the third embodiments, when the temperature is lowered to room temperature after the thermal treatment with the gradient temperature, it depends on the material whether a substantially constant gradient temperature, or a gradient temperature in accordance with the temperature is applied. Therefore, the application of the gradient temperature needs to be selected in accordance with the material, and here the application of the gradient temperature is not limited.

There is not any limitation to increase speed or decrease speed of the temperature, as long as a speed optimum for the gradient structure effect may be used. As to the thermal treatment with the gradient temperature, unless the gradient structure effect is adversely affected, the thermal treatment with a plurality of gradient temperatures may be repeated.

### [Examples]

Examples of the present invention will be described hereinafter.

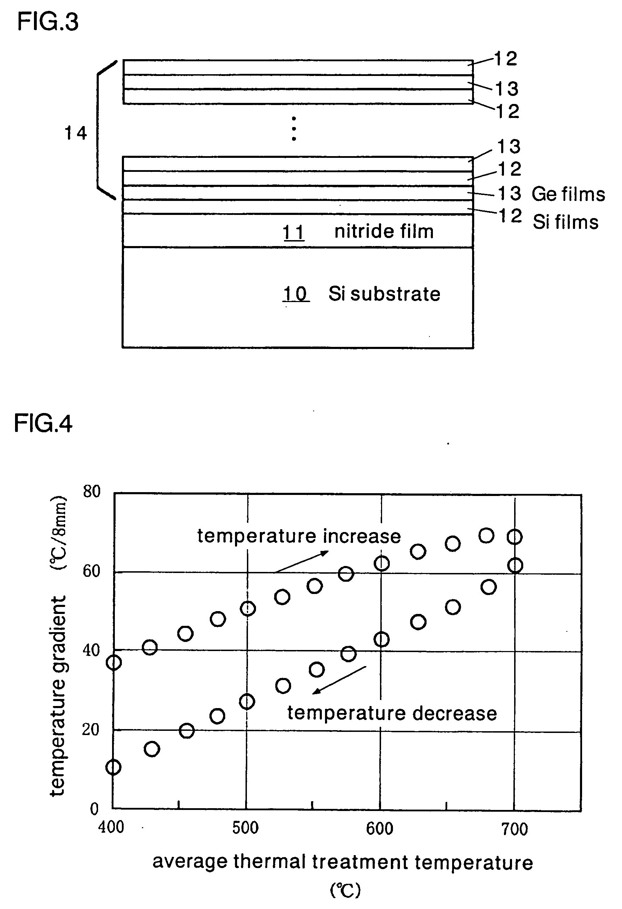

FIG. 3 schematically shows a film structure before thermal treatment in a thin film as one example. An oxide film or nitride film 11 is formed on a Si substrate 10, a desired substrate temperature is set, and Si films 12 (thickness is 3 nm) and Ge films 13 (thickness is 1 nm) containing impurities of B are prepared into a layer-by-layer stacked structure on the oxide film or nitride film by ion-sputtering film forming means to form a film having a structure in which fourteen layers are piled up.

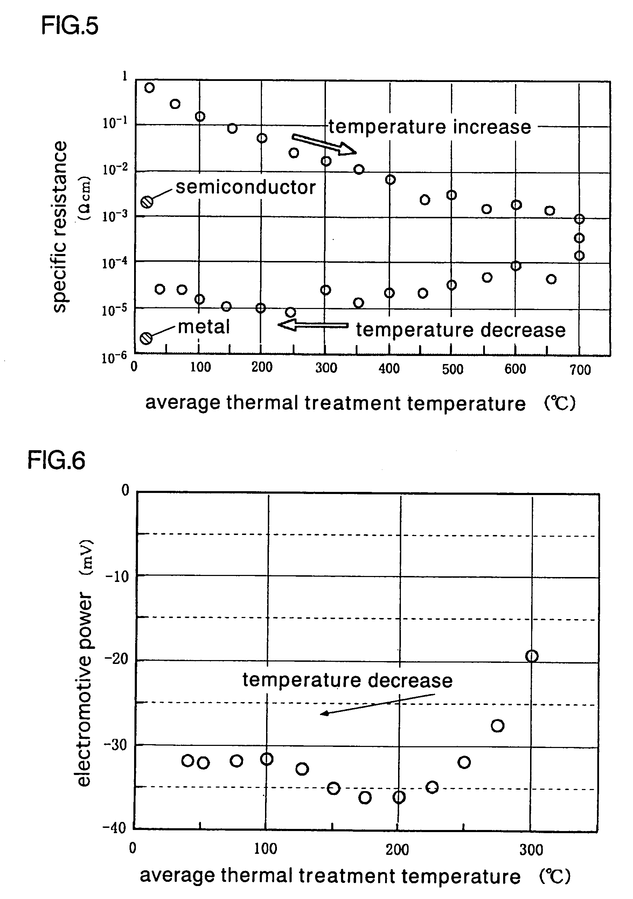

A distance is set to 8 mm between a high-temperature side heat sink and a low-temperature side heat sink, and the material is thermally treated with a relation between a gradient temperature (a larger gradient one is when the temperature increase) and an average thermal treatment temperature shown in FIG. 4. Accordingly, it has been clarified that a specific resistance of the thin film depends on the average thermal treatment temperature as shown in FIG. 5.

In the example of FIG. 4, the gradient temperature on the substrate was about 40 degree C per 8 mm when the temperature increase, and about 10 degree C per 8 mm when the temperature decrease at an average thermal treatment temperature of 400 degree C. The gradient was about 70 degree C per 8 mm when the temperature increase, and about 60 degree C per 8 mm when the temperature decrease at an average thermal treatment temperature of 700 degree C. A change of the gradient temperature with respect to a whole temperature increase speed indicated a substantially constant value of about 10 to 15 degree C per 8 mm per 100 degree C when the temperature increase or decrease.

The present sample was formed by an ion sputtering process, while a substrate temperature was set at room temperature. In FIG. 5, a specific resistance of about 0.8 Ωcm of the sample dropped with increase of the average thermal treatment temperature in room temperature, and was of the order of 10⁻⁴ Ωcm at an average thermal treatment temperature of 700 degree C. When the average thermal treatment temperature of this sample was slowly lowered (about 10 degree C per min), the resistance was of the order of 10⁻⁵ Ωcm in room temperature.

FIG. 5 shows specific resistances of a semiconductor and a metal at room temperature. Considering that a minimum specific resistance (in a case where a thermal treatment temperature is optimum) is about 3×10⁻³ Ωcm as shown in the thermal treatment of a SiGe thin film which is a semiconductor at a constant temperature, it is seen that the specific resistance of a SiGe thin film material decreases by two or more digits, when the material is subjected to the thermal treatment with the gradient temperature according to the present invention.

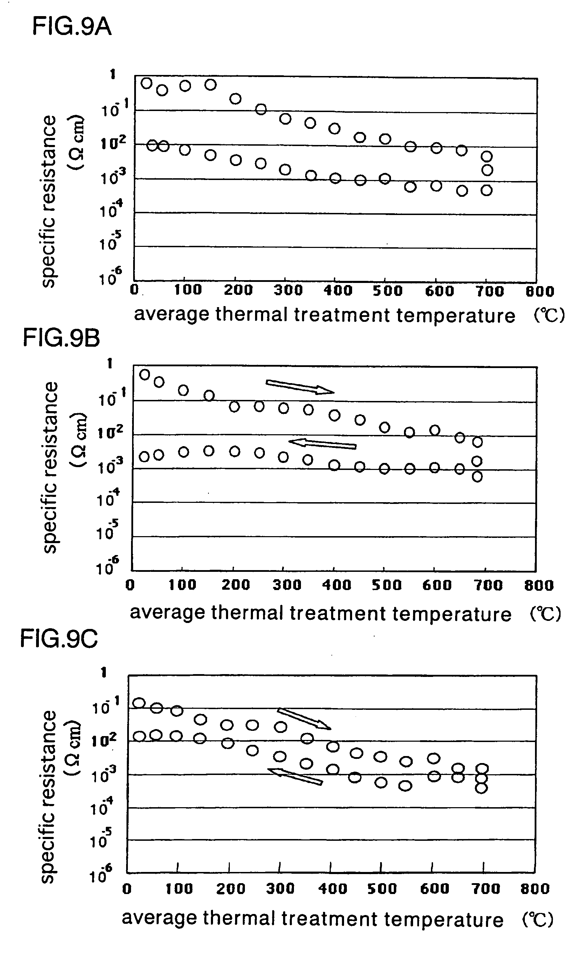

In room temperature, this small value of the specific resistance cannot be realized by a conventional thermal treatment of the SiGe semiconductor material at a constant temperature. When the value of the gradient temperature is smaller than that shown in FIG. 4, as shown in FIGS. 9A, 9B, 9C, the specific resistance of the material in room temperature was a value of the order of about 10⁻² Ωcm, which substantially equal to that in the thermal treatment at the constant temperature.

A phenomenon in which the specific resistance of the SiGe thin film is very small at room temperature appears only when an adequate gradient temperature is applied. Therefore, it can be said that the phenomenon is an influence of a gradient structure effect by the thermal treatment with the gradient temperature.

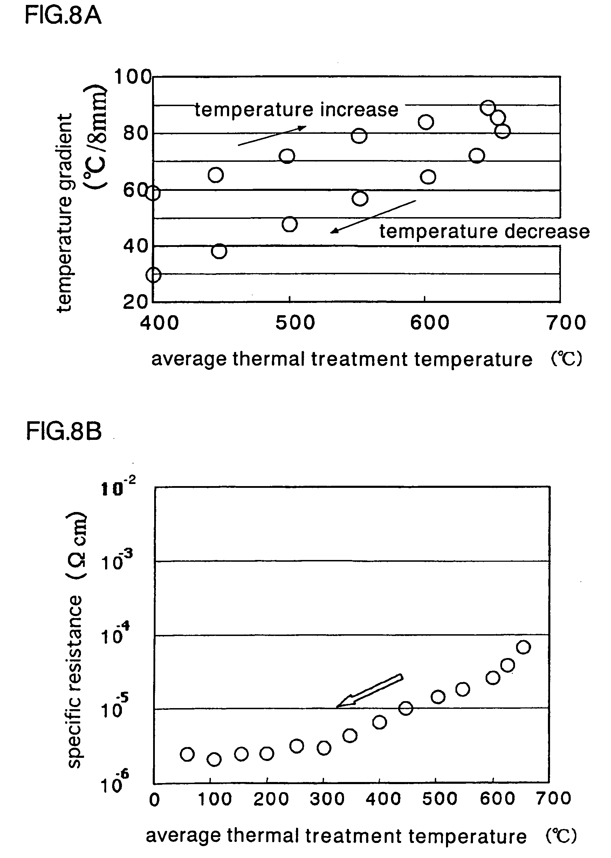

FIGS. 8A and 8B show another example of the present invention. In the figures, FIG. 8A shows a thermal treatment with a gradient temperature corresponding to FIG. 4, and FIG. 8B shows a specific resistance of a thin film corresponding to FIG. 5.

Also in the examples of FIGS. 8A and 8B, the specific resistance of a sample was about 0.8 Ωcm in room temperature, this specific resistance dropped with increase of an average thermal treatment temperature, and the resistance was of the order of 10⁻⁴ Ωcm at an average thermal treatment temperature of 700 degree C. When the average thermal treatment temperature was slowly lowered (about 10 degree C per minute), the resistance was of the order of 10⁻⁶ Ωcm in room temperature.

In the examples of FIGS. 8A and 8B, the gradient temperature on the substrate was about 60 degree C per 8 mm when the temperature increase, and about 30 degree C per 8 mm when the temperature decrease at an average thermal treatment temperature of 400 degree C. The gradient was about 90 degree C per 8 mm when the temperature increase, and about 70 degree C per 8 mm when the temperature decrease at an average thermal treatment temperature of 650 degree C. A change of the gradient temperature with respect to a whole temperature increase speed was about 15 to 20 degree C per 8 mm per 100 degree C when the temperature increase or decrease.

Therefore, it has been confirmed that a result similar to that of FIG. 5 is obtained in a different gradient temperature.

FIG. 6 shows electromotive voltages when an average thermal treatment temperature is changed while the same type and thermal treatment process as those of the material of FIG. 5 are used. Results are shown with respect to measurement in a state in which a high-temperature side of the gradient temperature is electrically connected to +, and a low-temperature side is electrically connected to -. Therefore, when a terminal is connected in reverse, needless to say, a + electromotive power is obtained.

In FIG. 6, an electromotive power of about 30 mV is generated in the vicinity of normal temperature. However, as shown in FIG. 5, an electric resistance is very small in a temperature range in which the electromotive voltage is generated, and it is therefore possible to take out a sufficient power by lamination. Therefore, application such as battery is possible.

As an electromotive voltage effect, there have heretofore been an optical electromotive voltage effect and a thermal electromotive voltage effect, but it has been confirmed that both the electromotive voltage effects are not produced in the present example. Therefore, a mechanism of the electromotive power is not known, but it can be said that the electromotive voltage effects of the gradient structure material is new.

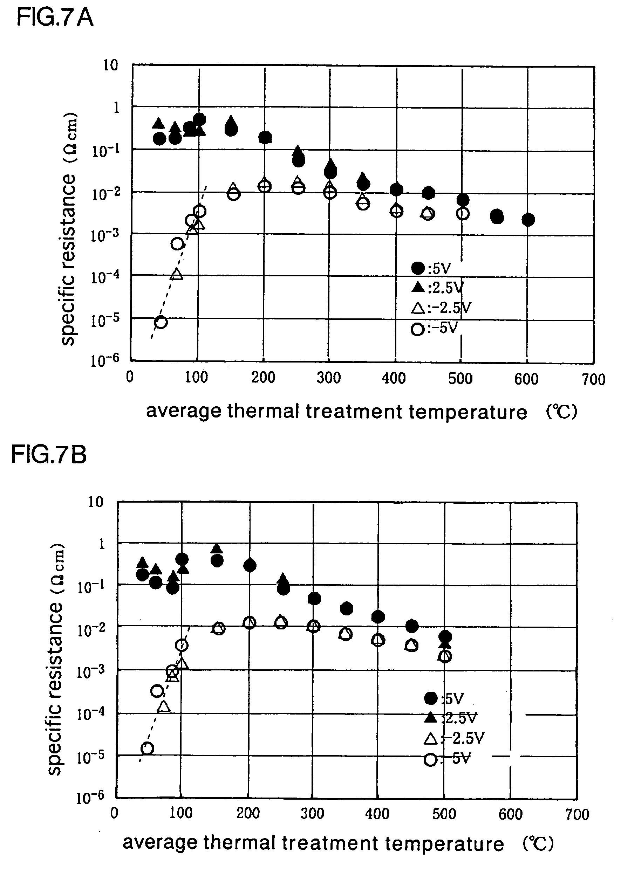

FIGS. 7A and 7B show specific resistance changes by different voltages when a gradient temperature was slightly different from that of the thermal treatment process of FIG. 5. In the figures, FIG. 7A shows that the temperature is lowered from a high average thermal treatment temperature after thermal treatment, and FIG. 7B shows results in a case where the temperature is raised from room temperature again after the thermal treatment.

In FIGS. 7A and 7B, ● and ▲ indicate specific resistances when voltage is applied in the same direction as that of the gradient temperature, and ○ and Δ indicate specific resistances when the voltage is applied in a reverse direction. It is seen from the figures that ● and ▲ are constantly larger than ○ and Δ by one or more digits in room temperature, and there is a strong rectifying function. This phenomenon is one of gradient structure effects, and there is a rectifying function only in a specific temperature range.

The application to a circuit which operate only at a specific temperature is possible using this rectifying function. Furthermore, the same use as that of a conventional pn diode is also possible. In this case, since there is not any pn-bonding interface, a destruction voltage is supposed to be high. When a minus voltage is applied in a direction opposite to a direction in which the gradient temperature is applied in room temperature, as shown by a broken line in the figure, a resistance change is very large with respect to the temperature, and additionally a specific resistance is small. Therefore, the application is also possible with respect to a bolometer-type infrared-ray detection having small power consumption.

A test piece (not shown) indicated color gradient at the time of thermal treatment with a gradient temperature of about 120 degree C per cm at a distance of 20 mm. The test piece was at about 700 degree C on a high-temperature side, and at about 460 degree C on a low-temperature side. The color apparently uniformly changed. This color is a structure color formed by the thermal treatment with the gradient temperature. In a material having a band gap corresponding to visible light, coloring is possible while the color gradient is applied by the thermal treatment with the gradient temperature. This is realized by the thermal treatment with the gradient temperature. Therefore, any coating material does not have to be used utilizing a conventional organic solvent, and eco-friendly coloring is possible.

In the above-described examples, the thin film has been described with respect to the layer-by-layer stacked structure of Si and Ge (impurities of B) of FIG. 3. However, the gradient structure effect is also confirmed even in a single-layer film of Ge (B impurities) or a ratio of Si to Ge (B impurities) layer. It is supposed that the gradient structure material is not related to the composition, type and the like of the material. Therefore, there is not any limitation to the composition ratio of Si/Ge (B), the number of stacked layers, film forming means and the like.

Moreover, a Si single-crystal substrate, nitride film/Si single crystal, or oxide film/Si single crystal is used as the substrate 1, but the phenomenon of the gradient structure effect is confirmed from the sample prepared at the substrate temperature corresponding to room temperature. Therefore, there is not any limitation to a state of the substrate 1. Furthermore, the phenomenon is confirmed by the use of the materials of Si and Ge which are suitable for a Si process. However, the gradient structure indicates the thermal treatment with the gradient temperature, and therefore the type of the material is not limited.

As to the functionality of the material, the functionality is related to the electric conductivity, the electromotive voltage is generated, and the color gradient phenomenon is indicated. Consequently, the physical properties associated with the electrically conductive carrier are influenced, the S/N is enhanced in forming the functional element, and therefore the functionality is not limited. Examples of the functionality associated with the electrically conductive carrier include an electric property, optical property, thermal property, magnetic property, thermoelectric property, photoelectric property, electromagnetic property, ferroelectric property, piezoelectric property, pyroelectric property, superconductivity and the like. These functionalities are not limited.

As described above, according to the gradient structure material and the functional element using this material according to the present invention, without applying the "gradient composition" of the component concentration, the content of oxide, the crystal structure or the like, a useful function, which has not heretofore been imparted, is imparted to the functional material on the substrate, or the performance can be enhanced unlike the conventional technique. Superior effects are produced in this manner.

It is to be noted that the present invention is not limited to the above-described example or embodiment, and, needless to say, the present invention can be variously modified without departing from the scope of the present invention.

## Claims

1. A gradient structure material comprising: a substrate and a functional material formed on the substrate, wherein the material is thermally treated while a desired gradient temperature is applied to a specific direction and a specific region of the functional material on the substrate.

2. The gradient structure material according to claim 1, wherein the functional material is in connection with properties of an electrically conductive carrier.

3. The gradient structure material according to claim 1 or 2, wherein the functional material on the substrate is heated while the desired gradient temperature is applied to the specific direction and the specific region with film formation.

4. The gradient structure material according to claim 1 or 2, wherein the functional material on the substrate is thermally treated while the desired gradient temperature is applied to the specific direction and the specific region after film formation.

5. The gradient structure material according to any one of claims 1 to 4, wherein the functional material on the substrate is thermally treated while the desired gradient temperature is applied to the specific direction and the specific region in a dilute reactive gas.

6. The gradient structure material according to any one of claims 1 to 5, wherein gradient temperature having the specific direction and the specific region are applied to a plurality of positions of the same functional material.

7. The gradient structure material according to any one of claims 1 to 6, wherein the gradient temperature of the specific direction and the specific region differs with a thermal treatment temperature.

8. The gradient structure material according to any one of claims 1 to 6, wherein the desired gradient temperature is substantially constant in a thermal treatment process.

9. The gradient structure material according to any one of claims 1 to 7, wherein the desired gradient temperature differs on a high-temperature side and a low-temperature side of thermal treatment.

10. The gradient structure material according to any one of claims 1 to 8, wherein the desired gradient temperature is substantially equal on a high-temperature side and a low-temperature side.

11. The gradient structure material according to any one of claims 1 to 10, wherein a material configuration of the functional material before the thermal treatment is amorphous.

12. The gradient structure material according to claim 11, wherein coefficients of thermal expansion of the thermally treated functional material and the substrate are substantially equal.

13. The gradient structure material according to any one of claims 1 to 12, wherein the functional material on the substrate comprises a single element or multiple elements, or a plurality of combinations of these elements.

14. The gradient structure material according to claim 13, wherein the functional material on the substrate contains various types of impurities of metal elements of the groups 2, 3, 5, 6.

15. The gradient structure material according to any one of claims 1 to 14, wherein a temperature is included which causes a phase transition phenomenon involving a rapid physical property change in a temperature range between a high-temperature side and a low-temperature side of thermal treatment of the functional material with the gradient temperature.

16. The gradient structure material according to any one of claims 1 to 15, wherein the functional material of the substrate is a Si-based, Ge-based, or SiGe-based semiconductor material, and can be used in a Si process.

17. The gradient structure material according to any one of claims 1 to 16, wherein the substrate comprises an oxide film or a nitride film formed on a Si substrate, and the functional material formed on the substrate is a film prepared into a layer-by-layer stacked structure of Si films and Ge films containing impurities of B.

18. The gradient structure material according to any one of claims 1 to 17, wherein the gradient temperature of the functional material on the substrate is in a range of about 40 to 60 degree C per 8 mm when the temperature increase, and in a range of about 10 to 30 degree C per 8 mm when the temperature decrease when an average thermal treatment temperature is 400 degree C, and a change of the gradient temperature with respect to a whole temperature increase speed is in a range of about 10 to 20 degree C per 8 mm per 100 degree C when the temperature increase, and in a range of about 10 to 20 degree C per 8 mm per 100 degree C when the temperature decrease.

19. A functional element using the gradient structure material according to any one of claims 2 to 18, wherein the functionality associated with the property of the electrically conductive carrier is an electric conductivity, and this characteristic is utilized.

20. A functional element using the gradient structure material according to any one of claims 2 to 18, wherein the functionality associated with the property of the electrically conductive carrier is a characteristic of an electromotive effect, and this characteristic is utilized.

21. The functional element according to claim 19 or 20, wherein a desired functional material on a substrate has a gradient treatment region where thermal treatment is performed with a gradient temperature, and a uniform treatment region where thermal treatment is performed at a constant temperature.

22. The functional element according to any one of claims 19 to 21, containing a pn-bonding in a part thereof.

23. The functional element according to any one of claims 19 to 22, wherein the desired functional material on the substrate comprises a stacked structure of a super lattice specific resistance, a layer-by-layer structure, a gradient structure structure, a multiple-element constitution, a stacked structure of different types of layered materials, or a combination of them.
